(19) Europäisches Patentamt / European Patent Office / Office européen des brevets

(11) **EP 2 692 689 B1**

(12) **FASCICULE DE BREVET EUROPEEN**

(45) Date de publication et mention de la délivrance du brevet: **06.03.2019 Bulletin 2019/10**

(51) Int Cl.: **B81C 1/00** (2006.01)

(21) Numéro de dépôt: **13178131.2**

(22) Date de dépôt: **26.07.2013**

(54) **Procédé d'encapsulation d'un dispositif microélectronique**

Einkapselungsverfahren einer mikroelektronischen Vorrichtung

Method for encapsulating a microelectronic device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2012 FR 1257418**

(43) Date de publication de la demande:
**05.02.2014 Bulletin 2014/06**

(73) Titulaire: **Commissariat à l'Énergie Atomique et aux Énergies Alternatives 75015 Paris (FR)**

(72) Inventeurs:
• **Nicolas, Stéphane**
  **38240 MEYLAN (FR)**
• **Baillin, Xavier**
  **38920 CROLLES (FR)**

(74) Mandataire: **Ahner, Philippe BREVALEX 95, rue d'Amsterdam 75378 Paris Cedex 8 (FR)**

(56) Documents cités:
WO-A1-2005/078458    DE-A1-102007 008 380
FR-A1- 2 841 380      US-A1- 2004 061 207
US-A1- 2007 259 470   US-B1- 7 659 150

• RIHUI HE ET AL: "On-Wafer Monolithic Encapsulation by Surface Micromachining With Porous Polysilicon Shell", JOURNAL OF MICROELECTROMECHANICAL SYSTEMS, IEEE SERVICE CENTER, US, vol. 16, no. 2, 1 avril 2007 (2007-04-01), pages 462-472, XP011176363, ISSN: 1057-7157, DOI: 10.1109/JMEMS.2007.892797

EP 2 692 689 B1

**Description**

**DOMAINE TECHNIQUE**

L'invention concerne un procédé d'encapsulation d'au moins un dispositif microélectronique tel qu'un microsystème de type MEMS (« Micro-Electro-Mechanical Systems »), NEMS (« Nano-Electro-Mechanical Systems »), MOEMS (« Micro-Opto-Electro-Mechanical Systems »), ou encore NOEMS (« Nano-Opto-Electro-Mechanical Systems »), dans une cavité hermétique dans laquelle au moins un gaz noble est enfermé avec une pression contrôlée.

**ÉTAT DE LA TECHNIQUE ANTÉRIEURE**

L'encapsulation d'un dispositif microélectronique tel qu'un dispositif de type MEMS permet d'une part de le protéger vis-à-vis des éléments extérieurs (humidité, pollution particulaire, éléments réactifs tels que l'oxygène ou d'autres gaz non neutres), et d'autre part de contrôler l'atmosphère (pression, nature du gaz environnant, etc.) régnant dans la cavité dans laquelle est encapsulé le dispositif microélectronique.

Par exemple, pour un dispositif de type gyroscope, une encapsulation de celui-ci dans un environnement sous vide (par exemple à une pression comprise entre environ 10 et 0.1Pa ($10^{-1}$ et $10^{-3}$ mbar)) est généralement nécessaire pour avoir un bon fonctionnement de ce type de dispositif. Pour un dispositif de type commutateur RF (Radio Fréquence), une encapsulation à une pression proche de la pression atmosphérique mais dans un environnement gazeux « neutre » est recherchée pour éviter par exemple une oxydation des zones de contact du commutateur. Il est dans ce cas nécessaire d'utiliser un gaz de type $N_2$, Ar, ou He pour réaliser l'encapsulation de ce type de dispositif.

Dans le cas d'une encapsulation d'un dispositif MEMS avec report de capot par scellement hermétique (cavité formée entre deux substrats solidarisés l'un à l'autre), le contrôle de la pression et de la nature du gaz dans la cavité dans laquelle le dispositif est encapsulé repose sur l'utilisation d'un équipement de scellement (« wafer bonder » en anglais) ayant la capacité de :

- contrôler la pression régnant dans la chambre de l'équipement de scellement avant la mise en contact et le scellement des deux substrats ;
- injecter un gaz neutre, par exemple de l'azote ou de l'argon, à une pression contrôlée dans la chambre de l'équipement de scellement.

Lors d'une telle encapsulation, le premier substrat sur lequel le dispositif est réalisé et le deuxième substrat destiné à former le capot de la cavité sont tout d'abord alignés l'un par rapport à l'autre dans la chambre de l'équipement de scellement ou à l'extérieur de celle-ci. Un support permet de maintenir mécaniquement les deux substrats alignés lors de leur chargement dans la chambre de l'équipement de scellement. Les deux substrats sont espacés l'un de l'autre par des calles et ne sont pas en contact l'un avec l'autre. Un vide est alors créé dans la chambre de l'équipement de scellement pour chasser l'air présent entre les deux substrats. Une consigne en pression égale à la pression d'encapsulation souhaitée est imposée dans la chambre. Parallèlement à cela, une injection de gaz neutre sous une pression contrôlée peut être réalisée dans la chambre de l'équipement de scellement puis les deux substrats sont mis en contact l'un avec l'autre et scellés hermétiquement, formant ainsi la cavité dans laquelle est encapsulé le dispositif.

Lorsqu'une telle encapsulation est mise en oeuvre collectivement en formant plusieurs cavités au sein desquelles plusieurs dispositifs sont encapsulés, il n'est pas possible d'avoir des atmosphères (pressions, etc.) différentes dans les différentes cavités.

Dans le cas d'une encapsulation du dispositif par un packaging couche mince (cavité formée entre un substrat et une couche mince formant le capot), le contrôle de l'atmosphère régnant dans la cavité est beaucoup plus difficile à réaliser. Une telle encapsulation consiste à mettre en oeuvre les étapes suivantes :

- dépôt et mise en forme d'une couche sacrificielle sur le substrat, recouvrant le dispositif,
- dépôt d'une couche mince, appelée couche capot, par exemple composée d'un semi-conducteur tel que du silicium, d'un oxyde ou d'un nitrure, destinée à former le capot et recouvrant la couche sacrificielle ;
- gravure de la couche capot afin de former des trous de libération traversant la couche capot,
- gravure de la couche sacrificielle à travers les trous de libération,
- bouchage hermétique des trous de libération par un dépôt d'une couche mince par exemple composée d'un semi-conducteur tel que du silicium, d'un oxyde, d'un nitrure ou d'un métal tel que du Ti ou de l'Al.

Or, l'étape de bouchage hermétique des trous de libération est réalisée dans des équipements de dépôt de type PECVD (dépôt chimique en phase vapeur assisté par plasma) ou PVD (dépôt physique en phase vapeur) qui ne peuvent fonctionner que dans une gamme restreinte de pressions, généralement inférieures à 500 Pa (5 mbar). Il est donc impossible de réaliser une telle encapsulation pour des dispositifs microélectroniques qui requièrent des pressions supérieures à 500 Pa (5 mbar), par exemple comprises entre 100 kPa (1 bar) et 500 Pa (5 mbar), pour fonctionner correctement.

Une solution pour résoudre ce problème consiste à introduire dans la cavité des matériaux susceptibles de dégazer après la fermeture hermétique de la cavité, engendrant ainsi une augmentation de la pression régnant dans la cavité. Toutefois, la valeur de la pression résiduelle obtenue dans la cavité, c'est-à-dire de la pression finale atteinte après un tel dégazage, est dans ce cas très difficile à maîtriser. Des exemples de tels procédés sont montrés dans les documents WO2005/078458, US2007/259470, DE102007008380 et FR2841380 par exemple.

## EXPOSÉ DE L'INVENTION

Un but de la présente invention est de proposer un procédé d'encapsulation d'au moins un dispositif microélectronique permettant de réaliser, au sein d'une cavité dans laquelle est encapsulé le dispositif, une atmosphère composée d'au moins un gaz non réactif vis-à-vis du dispositif, avec un très bon contrôle de la pression de ce gaz de la cavité, cette pression pouvant être supérieure ou inférieure à environ 5 mbar selon l'application envisagée.

Pour cela, la présente invention propose un procédé d'encapsulation d'au moins un dispositif microélectronique, comportant au moins les étapes de :

- encapsulation du dispositif microélectronique dans une cavité hermétique vis-à-vis de l'air, c'est-à-dire imperméable à l'air, et qui comporte au moins une paroi perméable à au moins un gaz noble ;
- injection du gaz noble dans la cavité à travers la paroi perméable au gaz noble ;
- fermeture hermétique de la cavité vis-à-vis de l'air et du gaz noble injecté dans la cavité.

Le terme « gaz noble » désigne ici un gaz ou un mélange de plusieurs gaz correspondant aux éléments chimiques du groupe 18 du tableau périodique des éléments, c'est-à-dire de l'hélium et/ou du néon et/ou de l'argon et/ou du krypton et/ou du xénon et/ou du radon, également appelés gaz rares, ou gaz chimiquement inertes. Le procédé est avantageusement mis en oeuvre pour un gaz noble comportant du néon et/ou de l'hélium et/ou de l'argon, notamment en raison des faibles dimensions des molécules de ces gaz, facilitant le passage de ce ou ces gaz à travers la paroi perméable.

Ainsi, à partir d'une cavité fermée hermétiquement vis-à-vis de l'air et dont au moins une des parois est tout ou partie perméable à au moins un gaz non réactif vis-à-vis du dispositif microélectronique, ce gaz non réactif est introduit dans la cavité à travers la paroi perméable de façon à obtenir avec précision la valeur de la pression résiduelle recherchée dans la cavité. La cavité est ensuite fermée hermétiquement vis-à-vis de l'air et de ce gaz, par exemple en déposant une couche écran non perméable à ce gaz, pour maintenir et stabiliser la pression finale obtenue dans ladite cavité.

Le procédé selon l'invention utilise donc le fait que certains matériaux, dont celui utilisé pour réaliser la paroi perméable de la cavité, sont perméables uniquement à un ou plusieurs gaz nobles, et notamment l'hélium et/ou le néon et/ou l'argon, et non-perméables à l'air.

Un tel procédé d'encapsulation peut être mis en oeuvre pour réaliser une encapsulation individuelle d'un ou plusieurs dispositifs microélectroniques, c'est-à-dire une encapsulation au niveau composant (par exemple après la découpe du substrat sur lequel le ou les dispositifs sont réalisés en puces unitaires), ou bien une encapsulation collective simultanée de plusieurs dispositifs microélectroniques réalisés sur un même substrat. Dans le cas d'une encapsulation collective, ce procédé autorise de réaliser des atmosphères différentes au sein des différentes cavités.

Le procédé d'encapsulation selon l'invention permet d'obtenir dans la cavité, une fois celle-ci fermée hermétiquement vis-à-vis de l'air et du gaz noble injecté, une pression pouvant aller de la pression atmosphérique, ou même de plusieurs bars, jusqu'à un vide poussé (par exemple jusqu'à environ $10^{-4}$ mbar).

Le capot de la cavité peut comporter la paroi perméable à au moins un gaz noble. Une telle configuration facilite l'injection du gaz noble dans la cavité, par exemple lorsque cette injection est réalisée à travers la paroi supérieure de la cavité.

L'étape d'encapsulation du dispositif microélectronique dans la cavité hermétique vis-à-vis de l'air peut avantageusement être réalisée sous vide, par exemple à une pression comprise entre environ $10^{-4}$ mbar et $10^{-5}$ mbar, ou encore inférieure à $10^{-5}$ mbar, ce qui permet de réduire la quantité de gaz résiduels réactifs se trouvant dans la cavité.

Le dispositif microélectronique peut être de type MEMS et/ou NEMS et/ou MOEMS et/ou NOEMS. Le procédé d'encapsulation selon l'invention peut avantageusement être mis en oeuvre pour réaliser l'encapsulation d'un dispositif MEMS et/ou NEMS de type inertiel, par exemple un accéléromètre ou un gyroscope, ou de type RF, par exemple un filtre BAW (filtre à ondes acoustiques de volume).

Le gaz noble peut être de l'hélium et/ou du néon et/ou de l'argon, et/ou la paroi perméable au gaz noble peut être composée d'oxyde de semi-conducteur (par exemple du $SiO_2$) et/ou de nitrure de semi-conducteur (par exemple du SiN ou du $Si_3N_4$) et/ou de verre. La paroi perméable au gaz noble peut notamment être composée de verre de type borosilicate, par exemple de type « pyrex », de verre de silice ou de verre de type « borofloat ».

L'encapsulation du dispositif microélectronique dans la cavité peut comporter la mise en oeuvre des étapes suivantes :

- réalisation du dispositif microélectronique sur au moins un premier substrat ;
- solidarisation d'au moins un deuxième substrat au premier substrat, formant la cavité hermétique vis-à-vis de l'air, la paroi perméable au gaz noble étant formée par une partie du deuxième substrat.

Le capot de la cavité correspond dans ce cas au moins à ladite partie du deuxième substrat.

La fermeture hermétique de la cavité vis-à-vis de l'air et du gaz noble peut comporter au moins un dépôt d'au moins une couche de matériau non perméable à l'air et au gaz noble recouvrant au moins la partie du deuxième substrat formant la paroi perméable au gaz noble.

L'encapsulation du dispositif microélectronique dans la cavité peut comporter la mise en oeuvre des étapes suivantes :

- réalisation du dispositif microélectronique sur au moins un premier substrat,
- réalisation d'au moins une portion de matériau sacrificiel recouvrant le dispositif microélectronique,
- dépôt d'au moins une couche capot sur le premier substrat, recouvrant la portion de matériau sacrificiel et comprenant au moins un matériau hermétique vis-à-vis de l'air,
- réalisation d'au moins une ouverture à travers la couche capot, formant au moins un accès à la portion de matériau sacrificiel,
- gravure de la portion de matériau sacrificiel via l'ouverture formée à travers la couche capot,
- bouchage de l'ouverture avec au moins un matériau hermétique vis-à-vis de l'air,

au moins une partie de la couche capot et/ou le matériau de bouchage de l'ouverture pouvant être perméable au gaz noble et former la paroi perméable au gaz noble,
l'injection du gaz noble dans la cavité pouvant être réalisée au moins à travers la paroi perméable au gaz noble.

Le capot de la cavité correspond dans ce cas au moins à ladite partie de la couche capot et/ou au matériau de bouchage.

La fermeture hermétique de la cavité vis-à-vis de l'air et du gaz noble peut comporter au moins un dépôt d'au moins une couche de matériau non perméable à l'air et au gaz noble telle qu'elle recouvre au moins le matériau hermétique vis-à-vis de l'air et perméable au gaz noble.

Le procédé d'encapsulation peut comporter en outre, entre l'encapsulation du dispositif microélectronique dans la cavité et l'injection du gaz noble dans la cavité, la réalisation d'au moins une portion de matériau non perméable au gaz noble recouvrant partiellement la partie du deuxième substrat formant la paroi perméable au gaz noble ou recouvrant partiellement le matériau hermétique vis-à-vis de l'air et perméable au gaz noble formant la paroi perméable au gaz noble. Ainsi, la portion de matériau non perméable au gaz noble forme un masque sélectif permettant un passage plus ou moins important du gaz noble dans la cavité.

La couche de matériau non perméable à l'air et au gaz noble peut être à base de semi-conducteur et/ou de métal.

Lors de l'encapsulation du dispositif microélectronique dans la cavité, au moins une portion de matériau getter peut être disposée dans la cavité, le procédé pouvant comporter en outre, pendant et/ou après la fermeture hermétique de la cavité vis-à-vis de l'air et du gaz noble, la mise en oeuvre d'une activation thermique de la portion de matériau getter.

Une telle portion de matériau getter permet d'assurer la qualité de l'atmosphère en piégeant par exemple les gaz résiduels tels que l'oxygène, l'azote, l'hydrogène, l'eau, le monoxyde ou le dioxyde de carbone, pouvant être présents dans la cavité, ce qui permet de maintenir dans la cavité uniquement une pression du gaz noble injecté.

L'étape d'encapsulation peut réaliser une encapsulation collective d'une pluralité de dispositifs microélectroniques dans plusieurs cavités hermétiques vis-à-vis de l'air et qui comportent chacune au moins une paroi perméable à au moins un gaz noble, l'étape d'injection de gaz noble pouvant être réalisée pour au moins une partie des cavités, et l'étape de fermeture hermétique peut être mise en oeuvre collectivement pour toutes les cavités. On réduit ainsi le coût lié à l'encapsulation des dispositifs microélectroniques. De plus, lorsque ce procédé est mis en oeuvre collectivement pour plusieurs dispositifs microélectroniques et que le procédé comporte la réalisation d'au moins une portion de matériau non perméable au gaz noble recouvrant partiellement et/ou totalement certaines des cavités, il est possible de réaliser simultanément des cavités pouvant présenter des pressions résiduelles différentes d'une cavité à l'autre du fait que ladite portion de matériau non perméable au gaz noble peut former alors un masque sélectif permettant un passage plus ou moins important du gaz noble dans chacune des cavités.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1A à 1D représentent les étapes d'un procédé d'encapsulation d'un dispositif microélectronique, objet de la présente invention, selon un premier mode de réalisation,
- les figures 2A à 2E représentent les étapes d'un procédé d'encapsulation de plusieurs dispositifs microélectroniques, objet de la présente invention, selon un deuxième mode de réalisation,
- les figures 3A à 3F représentent les étapes d'un procédé d'encapsulation d'un dispositif microélectronique, objet de la présente invention, selon un troisième mode de réalisation,
- les figures 4A à 4H représentent les étapes d'un procédé d'encapsulation de plusieurs dispositifs microélectroniques, objet de la présente invention, selon un quatrième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

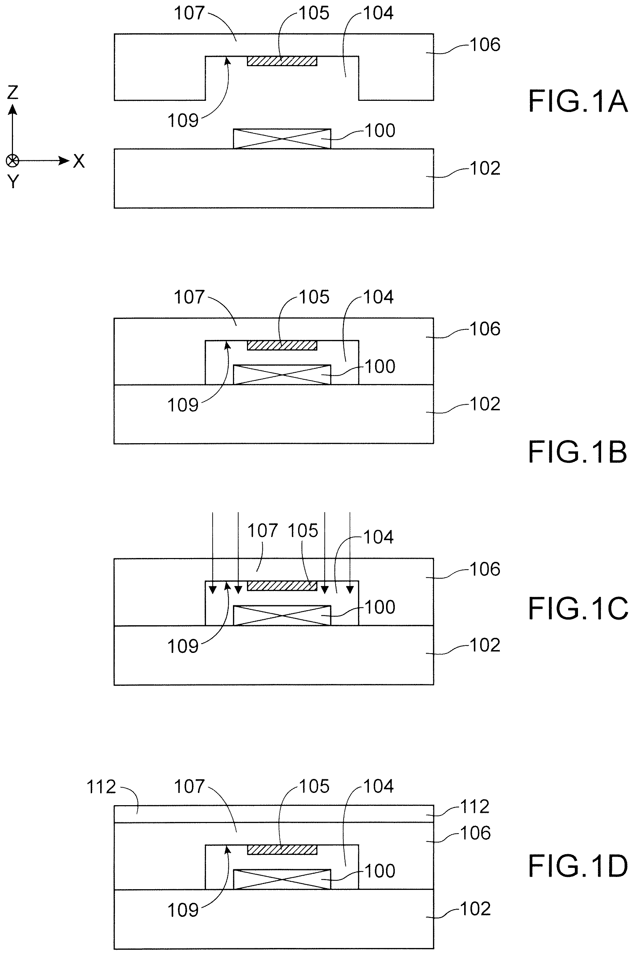

On se réfère tout d'abord aux figures 1A à 1E qui représentent les étapes d'un procédé d'encapsulation d'un dispositif microélectronique 100 selon un premier mode de réalisation.

Comme représenté sur la figure 1A, le dispositif microélectronique 100, ici de type MEMS, est réalisé au préalable sur un premier substrat 102, par exemple à base de semi-conducteur tel que du silicium.

Le dispositif 100 est destiné à être encapsulé dans une cavité 104 formée entre le premier substrat 102 et un deuxième substrat 106. Dans ce premier mode de réalisation, la cavité 104 est formée au préalable par gravure au niveau d'une face du second substrat 106 destinée à être disposée en regard du dispositif 100. Le premier substrat 102 et le deuxième substrat 106 correspondent à des couches de matériaux correspondant à des « wafers » dont les épaisseurs (dimension selon l'axe z représenté sur la figure 1A) sont par exemple supérieures à environ 1 $\mu$m.

Le deuxième substrat 106 comporte une partie 107 qui est perméable à au moins un gaz noble (de l'hélium dans ce premier mode de réalisation) destiné à être injecté dans la cavité 104 et qui forme une paroi 109 de la cavité 104 perméable à ce gaz noble. Cette perméabilité de la partie 107 du second substrat 106 vis-à-vis de l'hélium est obtenue de part la nature du matériau du second substrat 106, qui est ici à base de verre, tel que du verre de type borosilicate, par exemple de type « pyrex », du verre de silice ou du verre de type « borofloat », perméable à l'hélium, et également de l'épaisseur de cette partie 107 formant la paroi supérieure 109 de la cavité. Dans une variante de réalisation, le second substrat 106 pourrait être à base de tout matériau perméable au(x) gaz destiné(s) à être injecté(s) dans la cavité 104, par exemple en polymère tel que de l'époxy. De manière générale, l'épaisseur de la partie 107 du second substrat 106 formant la paroi perméable 109 de la cavité 104 peut avoir une épaisseur comprise entre environ 50 $\mu$m et 1 mm.

Dans ce premier mode de réalisation, une portion de matériau getter 105, par exemple composée d'un métal tel que du titane, est disposée contre une partie de cette paroi 109 telle que ce matériau getter soit destiné à être encapsulé dans la cavité 104 après la fermeture hermétique de celle-ci. Dans une variante, la portion de matériau getter 105 pourrait être réalisée sur une autre paroi de la cavité 104, par exemple au niveau d'au moins l'une des parois latérales de la cavité 104 ou bien sur le premier substrat 102, à côté du dispositif microélectronique 100. Il est également possible qu'aucun matériau getter ne soit présent dans la cavité 104.

Comme représenté sur la figure 1B, les deux substrats 102 et 106 sont solidarisés l'un à l'autre, tel que le dispositif 100 se trouve encapsulé dans la cavité 104 formée entre le deuxième substrat 106 et le premier substrat 102. Cette solidarisation des deux substrats 102 et 106 l'un à l'autre correspond à un scellement hermétique standard, sans injection de gaz dans la chambre de scellement. Ce scellement peut s'effectuer avantageusement sous vide, par exemple à une pression comprise entre environ $10^{-4}$ à $10^{-5}$ mbar (pression correspondant à celle régnant dans la chambre de scellement), cette pression se retrouvant donc dans la cavité 104 après le scellement, ce qui permet de réduire la quantité de gaz résiduels « réactifs » tels que l'oxygène, l'azote, l'hydrogène, l'eau, le monoxyde ou le dioxyde de carbone, éventuellement présents dans la cavité 104.

Dans une variante, il est possible que la solidarisation entre le premier substrat 102 et le deuxième substrat 106 soit réalisée par l'intermédiaire d'un cordon de scellement présent entre les deux substrats 102, 106. Dans ce cas, les parois latérales de la cavité 104 peuvent être tout ou partie formées par le cordon de scellement, et la hauteur de la cavité correspond au moins en partie à l'épaisseur du cordon de scellement.

Les deux substrats 102 et 106 scellés l'un à l'autre sont ensuite disposés dans une chambre hermétique permettant d'injecter le gaz noble, ici l'hélium, à travers la paroi 109 de la cavité 104 à une pression connue pendant un temps donné (voir figure 1C, sur laquelle l'injection d'hélium dans la cavité 104 à travers la paroi 109 est représentée symboliquement par des flèches 110). Compte tenu de la présence du matériau getter 105, l'hélium est injecté dans la cavité 104 à travers une partie seulement de la paroi 109 correspondant à la partie de la surface de la paroi 109 non recouverte par la portion de matériau getter 105. L'injection du gaz noble dans la cavité 104 est facilitée du fait que celle-ci est réalisée à travers le capot de la cavité 104, ici à travers la paroi supérieure 109 de la cavité 104.

En fonction de la pression (P) d'hélium, de la température (T) dans la chambre, de la surface (S) de la paroi 109 à travers laquelle le gaz noble peut être injecté (qui correspond ici à la partie de la surface de la paroi 109 non recouverte par la portion de matériau getter 105), à l'épaisseur (e) de matériau formant la paroi perméable 109 (c'est-à-dire l'épaisseur de la partie 107 du deuxième substrat 106), de la durée (t) de l'étape d'injection et du volume (V) de la cavité 104, on obtient dans la cavité 104 une pression $\Delta P$ égale à :

$$\Delta P = K.S.t.P/(e.V) \tag{1}$$

où K est un coefficient qui dépend de la température T et de la nature du matériau formant la paroi 109. A titre d'exemple, pour un deuxième substrat 106 composé de verre utilisé en scellement anodique (verre de dénominations commerciales « Pyrex » ou « Borofloat ») et pour les paramètres suivants : P = 1 bar, T = 20°C, t = 1200 s, S = 10 mm$^2$, e = 0,5 mm, et V = 0.3 mm$^3$, on obtient $\Delta P$ = 10$^{-1}$ mbar. Avec T = 100°C (les valeurs des autres paramètres étant similaires aux valeurs précédentes), une pression $\Delta P$ égale à 10$^{-1}$ mbar peut être atteinte avec une durée t égale à seulement 5 secondes.

Une couche 112 non perméable au gaz neutre injecté dans la cavité 104, ici une couche mince métallique, par exemple à base d'aluminium et/ou de titane, ou à base de semi-conducteur tel que du silicium, et d'épaisseur comprise entre environ 1 $\mu$m et 10 $\mu$m, est ensuite déposée sur le deuxième substrat 106 afin de recouvrir la partie 107 perméable au gaz injecté et empêcher que l'hélium piégé dans la cavité 104 puisse ressortir (voir figure 1D).

Le procédé d'encapsulation peut être achevé en réalisant une activation thermique de la portion de matériau getter 105, cette activation thermique pouvant également être réalisée au cours de l'assemblage des deux substrats 102 et 106. Le matériau getter 105 pompe alors les éventuels gaz résiduels non neutres présents dans la cavité 104. Par contre, les gaz neutres comme l'hélium ne sont pas pompés par le matériau getter car, du fait que les gaz nobles sont non réactifs, ils ne réagissent pas avec le getter.

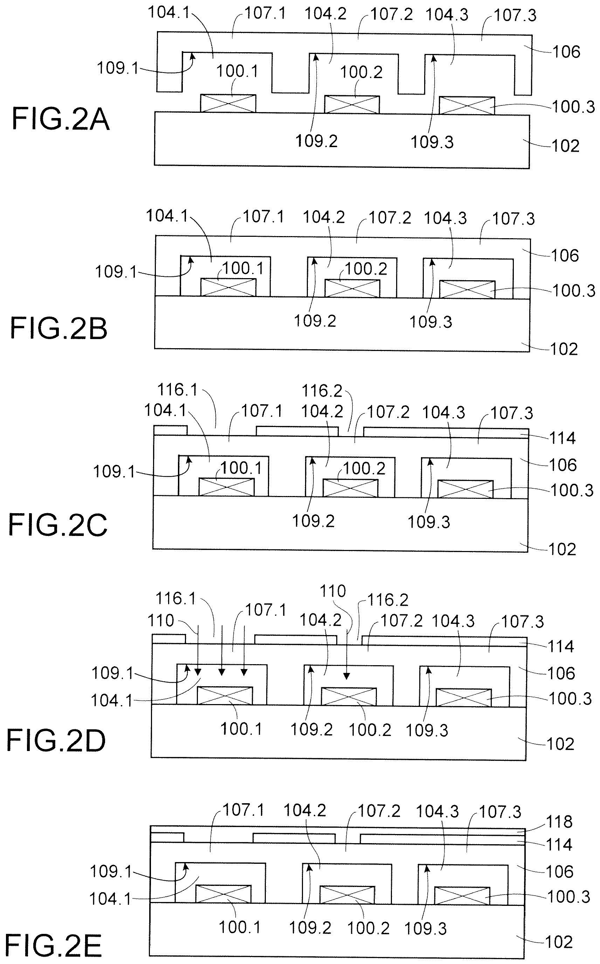

On décrit maintenant en liaison avec les figures 2A à 2E les étapes d'un procédé d'encapsulation collective de plusieurs dispositifs microélectroniques 100.1 - 100.3 selon un deuxième mode de réalisation.

Les dispositifs microélectroniques 100.1 - 100.3 (trois dans l'exemple décrit en liaison avec les figures 2A à 2E) sont réalisés sur le premier substrat 102. Plusieurs cavités 104.1 - 104.3 sont également formées dans le deuxième substrat 106, chaque dispositif 100.1 - 100.3 étant destiné à être encapsulé dans l'une des cavités 104.1-104.3.

Comme dans le premier mode de réalisation, les deux substrats 102 et 106 sont alignés l'un par rapport à l'autre puis solidarisés hermétiquement l'un à l'autre tel que les dispositifs 100.1 - 100.3 soient encapsulés individuellement dans chacune des cavités 104.1 - 104.3 formées entre le deuxième substrat 106 et le premier substrat 102 (figure 2B). Chacune des cavités 104.1 - 104.3 comporte au moins une paroi 109.1 - 109.3 perméable à au moins un gaz noble.

Une couche 114 hermétique (non perméable) vis-à-vis du gaz destiné à être injecté dans les cavités (ici de l'hélium) est formée sur le deuxième substrat 106. Cette couche 114, par exemple à base d'au moins un métal tel que du Ti ou de l'Al, et/ou de semi-conducteur tel que du silicium, est ensuite gravée afin de former des ouvertures alignées avec la ou les parois 109 à travers lesquelles le gaz est destiné à être injecté.

Ainsi, pour chaque cavité, il est possible de dimensionner l'ouverture formée à travers la couche 114 en fonction de la quantité de gaz à injecter dans la cavité. Sur l'exemple représenté sur la figure 2C, une première ouverture 116.1 est réalisée au niveau de la première cavité 104.1 et révèle la totalité ou la quasi-totalité de la surface de la paroi 109.1 de la cavité 104.1 perméable au gaz à injecter. Une deuxième ouverture 116.2 est réalisée dans la couche 114 en regard de la deuxième cavité 104.2. Par contre, contrairement à la première ouverture 116.1, cette deuxième ouverture 116.2 ne révèle qu'une partie de la surface de la paroi 109.2 de la cavité 104.2 perméable au gaz à injecter. L'ouverture 116.2 est donc dimensionnée en fonction de la quantité de gaz destiné à être injecté dans la cavité 104.2. Enfin, aucune ouverture n'est réalisée à travers la couche 114 au niveau la cavité 104.3 afin que lors de l'injection du gaz dans les cavités 104.1 et 104.2, aucun gaz ne soit injecté dans la troisième cavité 104.3 à travers la paroi 109.3.

On réalise ensuite une injection contrôlée d'hélium dans les cavités 104.1 et 104.2 à travers les parois supérieures 109.1 et 109.2 de ces cavités, c'est-à-dire à travers les parties 107.1 et 107.2 du deuxième substrat 106 (injection de gaz représentée symboliquement par les flèches 110). La quantité d'hélium pénétrant dans les cavités 104.1 et 104.2 est notamment fonction du taux d'ouverture de la couche 114 au-dessus de chaque cavité. En reprenant la formule (1) précédemment décrite en liaison avec le premier mode de réalisation, le taux d'ouverture de la couche 114 correspond à un coefficient compris entre 0 et 1 appliqué au paramètre (S), c'est-à-dire la surface de la paroi 109 à travers laquelle le gaz noble peut être injecté. Sur l'exemple de la figure 2D, la quantité d'hélium injecté est plus importante dans la première cavité 104.1 que dans la deuxième cavité 104.2. En ce qui concerne la troisième cavité 104.3, il n'y a pas d'injection d'hélium.

Ce deuxième mode de réalisation permet donc d'obtenir des pressions résiduelles différentes dans différentes cavités réalisées collectivement et simultanément à partir d'un même substrat formant les capots des cavités, cela étant en outre facilité par le fait que l'injection de gaz noble est réalisée à travers les capots, et notamment les parois supérieures 109.1 et 109.2, des cavités 104.1 et 104.2.

Comme représenté sur la figure 2E, une autre couche 118 hermétique au gaz injecté (hélium), par exemple à base d'au moins un métal et/ou d'au moins un semi-conducteur, est déposée au moins dans les ouvertures 116 réalisées à travers la couche 114 afin de fermer hermétiquement les cavités 104.1 - 104.3 vis-à-vis de l'air et du gaz injecté. Sur l'exemple de la figure 2E, la deuxième couche hermétique 118 est déposée sur toute la surface de la couche hermétique 114 et dans les ouvertures 116.1 et 116.2.

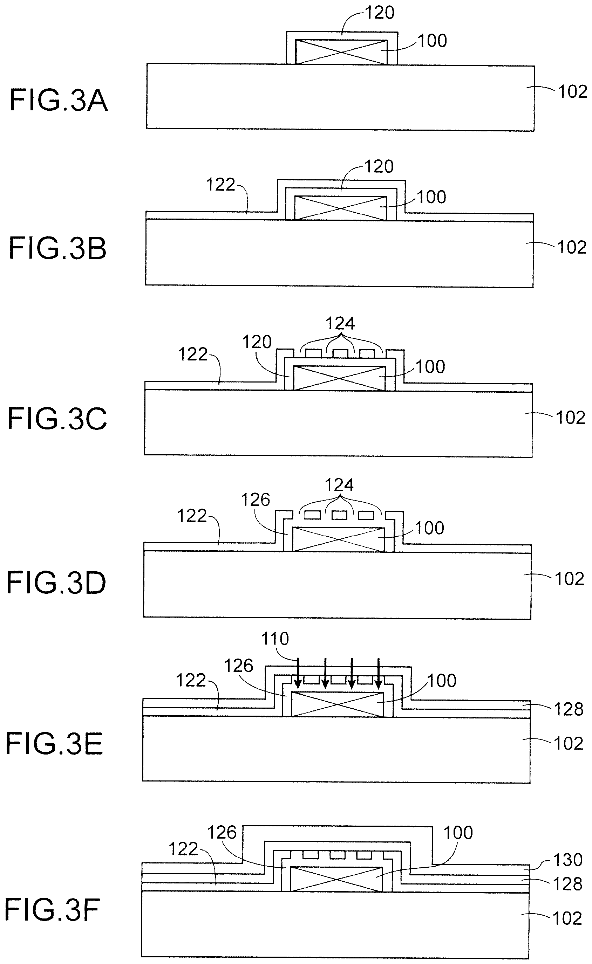

On décrit maintenant en liaison avec les figures 3A à 3F les étapes d'un procédé d'encapsulation d'un dispositif microélectronique selon un troisième mode de réalisation.

Comme dans le premier mode de réalisation, le dispositif microélectronique 100 est réalisé sur le substrat 102. Toutefois, contrairement aux deux précédents modes de réalisation, le dispositif 100 n'est pas destiné à être encapsulé en réalisant le report d'un deuxième substrat sur le substrat 102, mais en réalisant un capot comprenant une ou plusieurs couches minces. Comme représenté sur la figure 3A, une couche sacrificielle est déposée sur le premier substrat 102 en recouvrant le dispositif 100. Cette couche sacrificielle est mise en forme telle qu'une portion restante 120 de matériau sacrificiel recouvre le dispositif 100 en occupant un volume correspondant au volume souhaité de la cavité dans laquelle le dispositif 100 est destiné à être encapsulé.

Comme représenté sur la figure 3B, une couche de matériau 122 destinée à former le capot de la cavité dans laquelle le dispositif 100 est destiné à être encapsulé est ensuite déposée sur le substrat 102 en recouvrant la portion de matériau sacrificiel 120.

La couche 122, appelée couche capot, est une couche mince d'épaisseur par exemple inférieure à environ 10 $\mu$m et est à base de semi-conducteur tel que du silicium, d'oxyde de semi-conducteur ou de nitrure de semi-conducteur. Le matériau de cette couche capot 122 et celui de la portion de matériau sacrificiel 120 sont choisis tels qu'il soit possible de graver sélectivement le matériau sacrificiel de la portion 120 par rapport au matériau de la couche capot 122 (et également sans endommager le dispositif 100). La couche capot 122 peut également correspondre à un empilement de plusieurs couches.

Des ouvertures 124 sont ensuite réalisées, par exemple par gravure, à travers la couche capot 122 (à travers la partie de la couche capot 122 destinée à former la paroi supérieure de la cavité dans l'exemple décrit ici), formant ainsi des accès à la portion de matériau sacrificiel 120 à travers la couche capot 122 (figure 3C). La portion de matériau sacrificiel 120 est ensuite gravée à travers les ouvertures 124, par exemple via une gravure sèche isotrope (figure 3D). Le dispositif 100 se retrouve alors encapsulé dans une cavité 126 formée entre le substrat 102 et la couche capot 122.

On réalise ensuite un bouchage hermétique vis-à-vis de l'air des ouvertures 124 formées à travers la couche capot 122, fermant ainsi la cavité 126. Dans l'exemple décrit ici, ce bouchage hermétique est réalisé via le dépôt d'une couche mince de bouchage 128 par exemple à base d'oxyde de semi-conducteur, de nitrure de semi-conducteur, ou tout autre matériau hermétique vis-à-vis de l'air mais perméable au gaz destiné à être injecté dans la cavité 126 (figure 3E). Cette couche de bouchage 128 forme, avec les ouvertures 124, une paroi perméable au gaz destiné à être injecté dans la cavité 126. On réalise alors une injection du gaz noble (symbolisé par les flèches 110) dans la cavité 126 à travers la couche 128 et à travers les ouvertures 124 à une pression contrôlée et en un temps donné, comme décrit dans les modes de réalisation précédemment décrits. L'injection du gaz noble dans la cavité 126 est facilitée du fait que celle-ci est réalisée à travers le capot de la cavité 126, et notamment à travers la paroi supérieure de la cavité 126.

En reprenant la formule (1) précédemment décrite, et avec les paramètres suivants : P = 1 bar, T = 20°C, S = 10 mm$^2$, e = 5 $\mu$m, et V = 0.3 mm$^3$, on obtient une pression $\Delta P$ = 10$^{-1}$ mbar en réalisant l'injection d'hélium pendant une durée égale à environ 12 secondes. Il est toutefois possible de réduire le volume V de la cavité 126 et la surface de diffusion S d'un facteur 10 pour une telle encapsulation, et obtenir une valeur de $\Delta P$ sensiblement similaire du fait que $\Delta P$ est proportionnel à S/V, la réduction de ces deux paramètres d'un même facteur n'entrainant pas de variation de $\Delta P$.

Le procédé d'encapsulation est ensuite achevé en recouvrant la couche de bouchage 128 par une couche 130, par exemple à base de métal ou de semi-conducteur, hermétique au gaz injecté dans la cavité 126 afin de maintenir la pression obtenue dans la cavité 126 par la précédente injection de gaz (figure 3F).

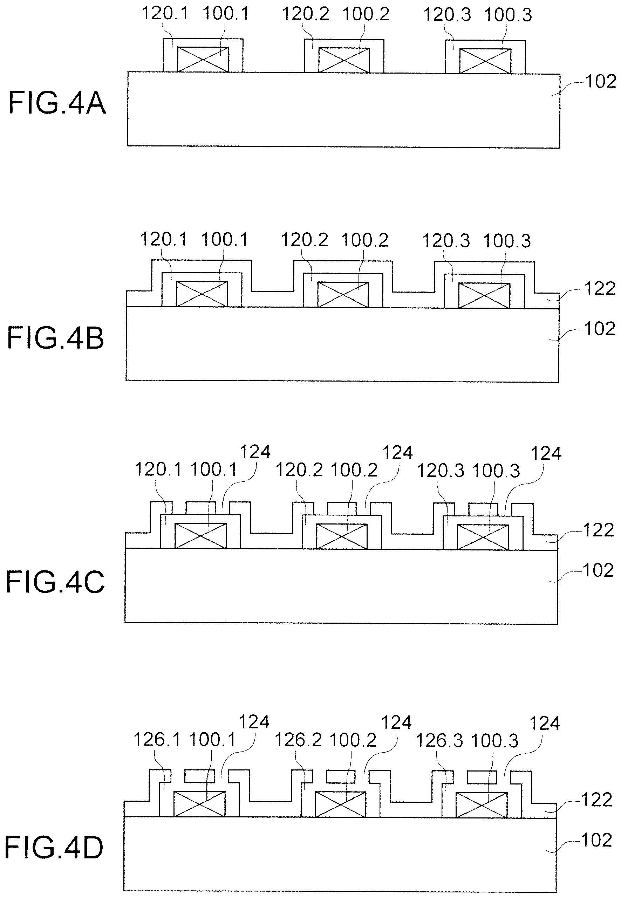

Une telle encapsulation par couche mince peut être mise en oeuvre pour réaliser une encapsulation collective de plusieurs dispositifs microélectroniques réalisés sur un même substrat. On décrit en liaison avec les figures 4A à 4H les étapes d'un procédé d'encapsulation collective de plusieurs dispositifs microélectroniques 100.1 - 100.3 selon un quatrième mode de réalisation.

Comme dans le deuxième mode de réalisation, plusieurs dispositifs microélectroniques 100.1 - 100.3 (trois dans l'exemple décrit en liaison avec les figures 4A à 4H) sont réalisés sur le premier substrat 102, chacun étant destiné à être encapsulé dans une cavité distincte.

Chaque dispositif 100.1 - 100.3 est recouvert d'une portion de matériau sacrificiel 120.1 - 120.3 similaire à la portion de matériau sacrificiel 120 précédemment décrite (figure 4A).

Le substrat 102 et les portions de matériau sacrificiel 120.1 - 120.3 sont ensuite recouverts au moins par la couche capot 122, analogue à celle précédemment décrite en liaison avec le troisième mode de réalisation (figure 4B).

Comme précédemment, des ouvertures 124 sont ensuite réalisées, par exemple par gravure, à travers la couche capot 122, formant ainsi des accès aux portions de matériau sacrificiel 120.1 - 120.3 à travers la couche capot 122 (figure 4C). Les portions de matériau sacrificiel 120.1 - 120.3 sont ensuite gravées à travers les ouvertures 124, par exemple via une gravure sèche isotrope (figure 4D). Chacun des dispositifs 100.1 - 100.3 se retrouve alors encapsulé individuellement dans une des cavités 126.1 - 126.3 formées entre le substrat 102 et la couche capot 122.

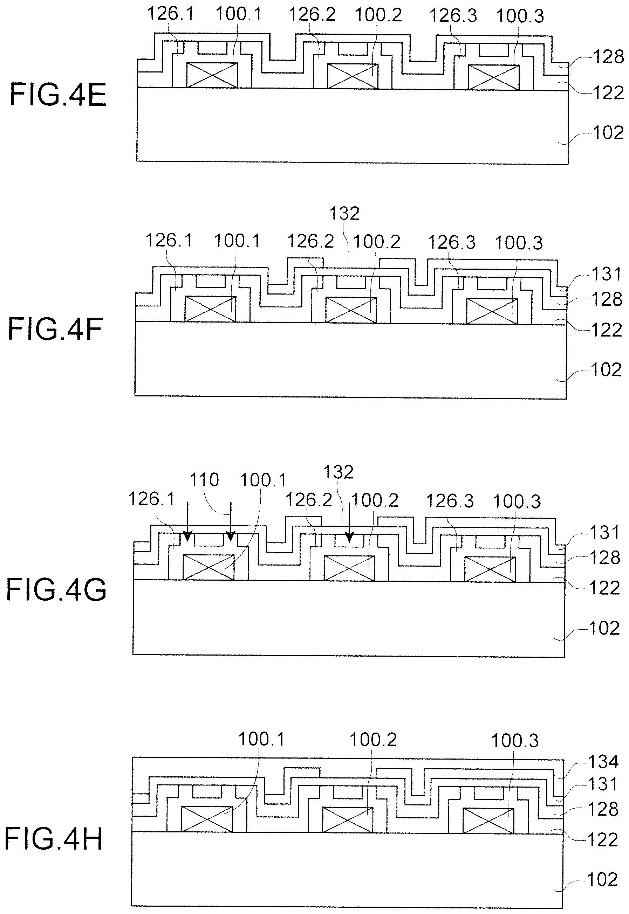

On réalise ensuite un bouchage hermétique vis-à-vis de l'air des ouvertures 124 formées à travers la couche capot 122, fermant ainsi les cavités 126.1 - 126.3, par exemple via le dépôt d'une couche mince de bouchage 128 similaire à celle précédemment décrite en liaison avec le troisième mode de réalisation (figure 4E).

Une couche 131 hermétique vis-à-vis du gaz destiné à être injecté dans les cavités (ici de l'hélium) est formée sur la couche de bouchage 128 (figure 4F). Cette couche hermétique 131 est par exemple de nature similaire à la couche 114 précédemment décrite en liaison avec le deuxième mode de réalisation. Cette couche hermétique 131 est ensuite gravée afin de former des ouvertures au niveau de la ou des parois (formées par la couche 128) à travers lesquelles le gaz est destiné à être injecté. Ainsi, pour chaque cavité, il est possible de dimensionner l'ouverture formée à travers la couche 131 en fonction de la quantité de gaz à injecté. Sur l'exemple représenté sur la figure 4F, la partie de la couche hermétique 131 se trouvant au-dessus de la première cavité 126.1 est complètement gravée afin de révéler la totalité de la surface de la paroi de la cavité 126.1 perméable au gaz à injecter. Une ouverture 132 est réalisée dans la couche 131 en regard de la deuxième cavité 126.2. Cette ouverture 132 ne révèle qu'une partie de la surface de la paroi de la cavité 126.2 perméable au gaz à injecter. L'ouverture 132 est dimensionnée en fonction de la quantité de gaz destinée à être injectée dans la cavité 126.2. Enfin, aucune ouverture n'est réalisée à travers la couche 131 au niveau la troisième cavité 126.3 afin que lors de l'injection du gaz dans les cavités 126.1 et 126.2, aucun gaz ne soit injecté dans la troisième cavité 126.3.

Comme représenté sur la figure 4G, on réalise alors une injection du gaz noble dans les cavités 126.1 et 126.2 à travers la couche 128 et à travers les ouvertures 124 à une pression contrôlée et en un temps donné, comme décrit dans les modes de réalisation précédemment décrits. La présence de la couche hermétique 131 empêche la diffusion de gaz dans la troisième cavité 126.3 et limite cette diffusion de gaz dans la deuxième cavité 126.2. Là encore, l'injection du gaz noble dans les cavités 126.1 et 126.2 est facilitée du fait que celle-ci est réalisée à travers les capots de ces cavités.

Le procédé d'encapsulation des dispositifs microélectroniques 100.1 - 100.3 est achevé en déposant une couche 134 hermétique au gaz injecté dans les cavités 126.1 et 126.2, par exemple similaire à la couche 130 précédemment décrit en liaison avec le troisième mode de réalisation et à base d'au moins un métal ou d'un semi-conducteur tel que du silicium (figure 4H).

Dans les deuxième, troisième et quatrième modes de réalisation, aucun matériau getter n'est présent dans les cavités formées. Toutefois, dans une variante de ces modes de réalisation, il est possible de réaliser une portion de matériau de getter dans une ou plusieurs des cavités formées.

Dans une variante des différents modes de réalisation précédemment décrits, il est possible que la paroi perméable au gaz soit formée dans le premier substrat 102 et/ou dans un cordon de scellement reliant les deux substrats 102 et 106 entre eux.

## Revendications

**1.** Procédé d'encapsulation d'au moins un dispositif microélectronique (100), comportant au moins les étapes de :

- encapsulation du dispositif microélectronique (100) dans une cavité (104, 126) hermétique vis-à-vis de l'air et dont un capot comporte au moins une paroi (109, 128) perméable à au moins un gaz noble (110),
- injection du gaz noble (110) dans la cavité (104, 126) à travers la paroi (109, 128) perméable au gaz noble (110),
- fermeture hermétique de la cavité (104, 126) vis-à-vis de l'air et du gaz noble (110) injecté dans la cavité (104, 126).

**2.** Procédé d'encapsulation selon la revendication 1, dans lequel le gaz noble (110) est de l'hélium et/ou du néon et/ou de l'argon, et/ou dans lequel la paroi (109, 128) perméable au gaz noble (110) est composée d'oxyde de semi-conducteur et/ou de nitrure de semi-conducteur et/ou de verre.

3.  Procédé d'encapsulation selon l'une des revendications précédentes, dans lequel l'encapsulation du dispositif microélectronique (100) dans la cavité (104) comporte la mise en oeuvre des étapes suivantes :

    - réalisation du dispositif microélectronique (100) sur au moins un premier substrat (102),
    - solidarisation d'au moins un deuxième substrat (106) au premier substrat (102), formant la cavité (104) hermétique vis-à-vis de l'air, la paroi (109) perméable au gaz noble (110) étant formée par une partie (107) du deuxième substrat (106).

4.  Procédé d'encapsulation selon la revendication 3, dans lequel la fermeture hermétique de la cavité (104) vis-à-vis de l'air et du gaz noble (110) comporte au moins un dépôt d'au moins une couche (112, 118) de matériau non perméable à l'air et au gaz noble (110) recouvrant au moins la partie (107) du deuxième substrat (106) formant la paroi (109) perméable au gaz noble (110).

5.  Procédé d'encapsulation selon l'une des revendications 1 ou 2, dans lequel l'encapsulation du dispositif microélectronique (100) dans la cavité (126) comporte la mise en oeuvre des étapes suivantes :

    - réalisation du dispositif microélectronique (100) sur au moins un premier substrat (102),
    - réalisation d'au moins une portion de matériau sacrificiel (120) recouvrant le dispositif microélectronique (100),
    - dépôt d'au moins une couche capot (122) sur le premier substrat (102), recouvrant la portion de matériau sacrificiel (120) et comprenant au moins un matériau hermétique vis-à-vis de l'air,
    - réalisation d'au moins une ouverture (124) à travers la couche capot (122), formant au moins un accès à la portion de matériau sacrificiel (120),
    - gravure de la portion de matériau sacrificiel (120) via l'ouverture (124) formée à travers la couche capot (122),
    - bouchage de l'ouverture (124) avec au moins un matériau (128) hermétique vis-à-vis de l'air,

    dans lequel au moins une partie de la couche capot (122) et/ou le matériau (128) de bouchage de l'ouverture (124) est perméable au gaz noble (110) et forme la paroi (128) perméable au gaz noble (110),
    et dans lequel l'injection du gaz noble (110) dans la cavité (126) est réalisée au moins à travers la paroi (128) perméable au gaz noble (110).

6.  Procédé d'encapsulation selon la revendication 5, dans lequel la fermeture hermétique de la cavité (126) vis-à-vis de l'air et du gaz noble (110) comporte au moins un dépôt d'au moins une couche (130, 134) de matériau non perméable à l'air et au gaz noble (110) telle qu'elle recouvre au moins le matériau (128) hermétique vis-à-vis de l'air et perméable au gaz noble (110).

7.  Procédé d'encapsulation selon l'une des revendications 3 à 6, comportant en outre, entre l'encapsulation du dispositif microélectronique (100) dans la cavité (104, 126) et l'injection du gaz noble (110) dans la cavité (104, 126), la réalisation d'au moins une portion (114, 131) de matériau non perméable au gaz noble (110) recouvrant partiellement la partie (107) du deuxième substrat (106) formant la paroi (109) perméable au gaz noble (110) ou recouvrant partiellement le matériau (128) hermétique vis-à-vis de l'air et perméable au gaz noble (110) formant la paroi perméable au gaz noble (110).

8.  Procédé d'encapsulation selon la revendication 4 ou 6 ou 7, dans lequel la couche (112, 118, 130, 134) de matériau non perméable à l'air et au gaz noble (110) est à base de semi-conducteur et/ou de métal.

9.  Procédé d'encapsulation selon l'une des revendications précédentes, dans lequel, lors de l'encapsulation du dispositif microélectronique (100) dans la cavité (104, 126), au moins une portion de matériau getter (105) est disposée dans la cavité (104, 126), le procédé comportant en outre, pendant et/ou après la fermeture hermétique de la cavité (104, 126) vis-à-vis de l'air et du gaz noble (110), la mise en oeuvre d'une activation thermique de la portion de matériau getter (105).

10. Procédé d'encapsulation selon l'une des revendications précédentes, dans lequel l'étape d'encapsulation réalise une encapsulation collective d'une pluralité de dispositifs microélectroniques (100.1 - 100.3) dans plusieurs cavités (104.1 - 104.3 ; 126.1 - 126.3) hermétiques vis-à-vis de l'air et qui comportent chacune au moins une paroi (109.1 - 109.3 ; 128) perméable à au moins un gaz noble (110), dans lequel l'étape d'injection de gaz noble (110) est réalisée pour au moins une partie des cavités (104.1, 104.2, 126.1, 126.2), et dans lequel l'étape de fermeture hermétique est mise en oeuvre collectivement pour toutes les cavités (104.1 - 104.3 ; 126.1 - 126.3).

**Patentansprüche**

1.  Verfahren zum Einkapseln zumindest einer mikroelektronischen Vorrichtung (100), umfassend zumindest die nachstehenden Schritte:

    - Einkapseln der mikroelektronischen Vorrichtung (100) in einen luftdichten Hohlraum (104, 126), von welchem eine Abdeckung zumindest eine gegenüber zumindest einem Edelgas (110) durchlässige Wand (109, 128) aufweist,
    - Einleiten des Edelgases (110) in den Hohlraum (104, 126) durch die gegenüber dem Edelgas (110) durchlässige Wand (109, 128),
    - gegenüber der Luft und dem in den Hohlraum (104, 126) eingeleiteten Edelgas (110) dichtes Verschließen des Hohlraums (104, 126).

2.  Einkapselungsverfahren nach Anspruch 1, wobei das Edelgas (110) Helium und/oder Neon und/oder Argon ist und/oder wobei die gegenüber dem Edelgas (110) durchlässige Wand (109, 128) aus Halbleiteroxid und/oder Halbleiternitrid und/oder Glas besteht.

3.  Einkapselungsverfahren nach einem der vorangehenden Ansprüche, wobei das Einkapseln der mikroelektronischen Vorrichtung (100) in den Hohlraum (104) das Ausführen nachstehender Schritte umfasst:

    - Herstellen der mikroelektronischen Vorrichtung (100) auf zumindest einem ersten Substrat (102),
    - festes Verbinden zumindest eines zweiten Substrats (106) mit dem ersten Substrat (102), wodurch der luftdichte Hohlraum (104) gebildet wird, wobei die gegenüber dem Edelgas (110) durchlässige Wand (109) aus einem Teil (107) des zweiten Substrats (106) gebildet wird.

4.  Einkapselungsverfahren nach Anspruch 3, wobei das gegenüber Luft und dem Edelgas (110) dichte Verschließen des Hohlraums (104) zumindest ein Aufbringen von zumindest einer Schicht (112, 118) aus gegenüber Luft und dem Edelgas (110) nicht durchlässigem Material umfasst, die zumindest den Teil (107) des zweiten Substrats (106) überdeckt, welcher die gegenüber dem Edelgas (110) durchlässige Wand (109) bildet.

5.  Einkapselungsverfahren nach einem der Ansprüche 1 oder 2, wobei das Einkapseln der mikroelektronischen Vorrichtung (100) in den Hohlraum (126) das Ausführen nachstehender Schritte umfasst:

    - Herstellen der mikroelektronischen Vorrichtung (100) auf zumindest einem ersten Substrat (102),
    - Herstellen zumindest eines Opfermaterialabschnitts (120), der die mikroelektronische Vorrichtung (100) überdeckt,
    - Aufbringen von zumindest einer Deckschicht (122) auf das erste Substrat (102), welche den Opfermaterialabschnitt (120) überdeckt und zumindest ein luftdichtes Material enthält,
    - Herstellen zumindest einer Öffnung (124) durch die Deckschicht (122) hindurch, wodurch zumindest ein Zugang zu dem Opfermaterialabschnitt (120) gebildet wird,
    - Ätzen des Opfermaterialabschnitts (120) durch die durch die Deckschicht (122) hindurch gebildete Öffnung (124),
    - Verschließen der Öffnung (124) mit zumindest einem luftdichten Material (128),

    wobei zumindest ein Teil der Deckschicht (122) und/oder das Material (128) zum Verschließen der Öffnung (124) gegenüber dem Edelgas (110) durchlässig ist und die gegenüber dem Edelgas (110) durchlässige Wand (128) bildet, und wobei das Einleiten von Edelgas (110) in den Hohlraum (126) zumindest durch die gegenüber dem Edelgas (110) durchlässige Wand (128) hindurch erfolgt.

6.  Einkapselungsverfahren nach Anspruch 5, wobei das gegenüber Luft und dem Edelgas (110) dichte Verschließen des Hohlraums (126) zumindest ein Aufbringen von zumindest einer Schicht (130, 134) aus gegenüber Luft und dem Edelgas (110) nicht luftdurchlässigem Material umfasst, derart, dass sie zumindest das gegenüber Luft dichte und gegenüber dem Edelgas (110) durchlässige Material überdeckt.

7. Einkapselungsverfahren nach einem der Ansprüche 3 bis 6, ferner umfassend zwischen dem Einkapseln der mikroelektronischen Vorrichtung (100) in den Hohlraum (104, 126) und dem Einleiten von Edelgas (110) in den Hohlraum (104, 126) das Herstellen zumindest eines Abschnitts (114, 131) aus gegenüber dem Edelgas (110) nicht durchlässigem Material, der teilweise den Teil (107) des zweiten Substrats (106) überdeckt, welcher die gegenüber dem Edelgas (110) durchlässige Wand (109) bildet oder das gegenüber Luft dichte und gegenüber dem Edelgas (110) durchlässige Material (128) teilweise überdeckt, das die gegenüber dem Edelgas (110) durchlässige Wand bildet.

8. Einkapselungsverfahren nach Anspruch 4 oder 6 oder 7, wobei die Schicht (112, 118, 130, 134) aus gegenüber Luft und dem Edelgas (110) nicht durchlässigem Material auf Halbleiter- und/oder Metallbasis besteht.

9. Einkapselungsverfahren nach einem der vorangehenden Ansprüche, wobei bei dem Einkapseln der mikroelektronischen Vorrichtung (100) in den Hohlraum (104, 126) zumindest ein Gettermaterialabschnitt (105) in den Hohlraum (104, 126) angeordnet wird, wobei das Verfahren ferner während und/oder nach dem gegenüber Luft und dem Edelgas (110) dichten Verschließen das Ausführen einer thermischen Aktivierung des Gettermaterialabschnitts (105) umfasst.

10. Einkapselungsverfahren nach einem der vorangehenden Ansprüche, wobei mit dem Schritt des Einkapselns ein kollektives Einkapseln einer Mehrzahl von mikroelektronischen Vorrichtungen (100.1 - 100.3) in mehrere luftdichte Hohlräume (104.1 - 104.3; 126.1 - 126.3) erfolgt, die jeweils zumindest eine gegenüber zumindest einem Edelgas (110) durchlässige Wand (109.1 - 109.3; 128) enthalten, wobei der Schritt des Einleitens von Edelgas (110) für zumindest einen Teil der Hohlräume (104.1, 104.2, 126.1, 126.2) erfolgt und wobei der Schritt des dichten Verschließens kollektiv für alle Hohlräume (104.1 - 104.3; 126.1 - 126.3) erfolgt.

**Claims**

1. Method of encapsulating at least one microelectronic device (100), comprising at least the following steps:

   - encapsulate the microelectronic device (100) in a cavity (104, 126) hermetically sealed against air, a cap of the cavity comprising at least one wall (109, 128) permeable to at least one noble gas (110),
   - inject the noble gas (110) into the cavity (104, 126) through the wall (109, 128) permeable to the noble gas (110),
   - hermetically seal the cavity (104, 126) against air and the noble gas (110) injected into the cavity (104, 126).

2. Encapsulation method according to claim 1, in which the noble gas (110) is helium and/or neon, and/or argon, and/or in which the wall (109, 128) permeable to the noble gas (110) comprises semiconducting oxide and/or semiconducting nitride and/or glass.

3. Encapsulation method according to one of previous claims, in which encapsulation of the microelectronic device (100) in the cavity (104) includes the following steps:

   - make the microelectronic device (100) on at least one first substrate (102),
   - bond at least one second substrate (106) to the first substrate (102), forming the cavity (104) hermetically sealed against air, the wall (109) permeable to the noble gas (110) being formed by part (107) of the second substrate (106).

4. Encapsulation method according to claim 3, in which the cavity (104) is hermetically sealed against air and the noble gas (110) by at least one deposition of at least one layer (112, 118) of material impermeable to air and the noble gas (110) covering at least the part (107) of the second substrate (106) forming the wall (109) permeable to the noble gas (110).

5. Encapsulation method according to either claim 1 or 2, in which encapsulation of the microelectronic device (100) in the cavity (126) includes the following steps:

   - make the microelectronic device (100) on at least one first substrate (102),
   - make at least one portion of sacrificial material (120) covering the microelectronic device (100),
   - deposit at least one cap layer (122) on the first substrate (102), covering the portion of sacrificial material (120) and comprising at least one material impermeable to air,

- make at least one opening (124) through the cap layer (122), forming at least one access to the portion of sacrificial material (120),
- etch the portion of sacrificial material (120) through the opening (124) formed through the cap layer (122),
- close the opening (124) with at least one material (128) impermeable to air,

in which at least part of the cap layer (122) and/or the sealing material (128) of the opening (124) is permeable to the noble gas (110) and form(s) the wall (128) permeable to the noble gas (110),
and in which the noble gas (110) is injected into the cavity (126) through at least the wall (128) permeable to the noble gas (110).

6. Encapsulation method according to claim 5, in which hermetic sealing of the cavity (126) against air and the noble gas (110) comprises at least one deposition of at least one layer (130, 134) of a material impermeable to air and the noble gas (110) such that it covers at least the material (128) impermeable to air and permeable to the noble gas (110).

7. Encapsulation method according to one of claims 3 to 6, also including making at least one portion (114, 131) of material impermeable to the noble gas (110) partially covering the part (107) of the second substrate (106) forming the wall (109) permeable to the noble gas (110) or partially covering the material (128) impermeable to air and permeable to the noble gas (110) forming the wall permeable to the noble gas (110), between encapsulation of the microelectronic device (100) in the cavity (104, 126) and injection of the noble gas (110) into the cavity (104, 126).

8. Encapsulation method according to claim 4 or 6 or 7, in which the layer (112, 118, 130, 134) of material impermeable to air and to the noble gas (110) comprises a semiconductor and/or metal.

9. Encapsulation method according to one of previous claims, in which, when the microelectronic device (100) is encapsulated in the cavity (104, 126), at least one portion of getter material (105) is arranged in the cavity (104, 126), the method also comprising a thermal activation of the portion of getter material (105) during and/or after hermetic sealing of the cavity (104, 126) against air and the noble gas (110).

10. Encapsulation method according to one of previous claims, in which the encapsulation step comprises a collective encapsulation of a plurality of microelectronic devices (100.1 - 100.3) in several cavities (104.1 - 104.3 ; 126.1 - 126.3) hermetically sealed against air, each of which comprises at least one wall (109.1 - 109.3 ; 128) permeable to at least one noble gas (110), in which the step to inject the noble gas (110) is done for at least some of the cavities (104.1, 104.2, 126.1, 126.2), and in which the hermetic sealing step is applied collectively for all the cavities (104.1 - 104.3 ; 126.1 - 126.3).

FIG.1A

FIG.1B

FIG.1C

FIG.1D

FIG.2A

FIG.2B

FIG.2C

FIG.2D

FIG.2E

FIG.3A

FIG.3B

FIG.3C

FIG.3D

FIG.3E

FIG.3F

FIG.4A

FIG.4B

FIG.4C

FIG.4D

FIG.4E

126.1  100.1  126.2  100.2  126.3  100.3

128

122

102

FIG.4F

132

126.1  100.1  126.2  100.2  126.3  100.3

131

128

122

102

FIG.4G

110  100.1  132

126.1  126.2  100.2  126.3  100.3

131

128

122

102

FIG.4H

100.1  100.2  100.3

134

131

128

122

102

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005078458 A
- US 2007259470 A
- DE 102007008380
- FR 2841380